(19) Europäisches Patentamt
European Patent Office
Office européen des brevets

(11) EP 3 636 678 B1

(12) **EUROPEAN PATENT SPECIFICATION**

(45) Date of publication and mention of the grant of the patent:
**17.01.2024 Bulletin 2024/03**

(21) Application number: **18798327.5**

(22) Date of filing: **20.04.2018**

(51) International Patent Classification (IPC):
***C08F 12/24*** (2006.01) ***C08F 12/22*** (2006.01)
***C08F 212/14*** (2006.01) ***C08F 8/00*** (2006.01)
***C09D 125/18*** (2006.01) ***G03C 1/72*** (2006.01)
***G03F 7/00*** (2006.01) ***C08G 59/20*** (2006.01)

(52) Cooperative Patent Classification (CPC):
(C-Sets available)
**C08F 12/22; C08F 8/00; C08F 212/22; C08F 212/24; C08G 59/063; C09D 125/18; G03F 7/0045; G03F 7/038; G03F 7/0382** (Cont.)

(86) International application number:
**PCT/CN2018/083911**

(87) International publication number:
**WO 2018/205818 (15.11.2018 Gazette 2018/46)**

(54) **POLY(P-HYDROXYSTYRENE) EPOXY RESIN, AND SYNTHESIS AND USE THEREOF**

POLY(P-HYDROXYSTYROL)-EPOXIDHARZ UND SYNTHESE UND VERWENDUNG DAVON

RÉSINE ÉPOXY À BASE DE POLY(P-HYDROXYSTYRÈNE), ET SYNTHÈSE ET UTILISATION DE CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.05.2017 CN 201710334491**

(43) Date of publication of application:
**15.04.2020 Bulletin 2020/16**

(73) Proprietor: **Hubei Gurun Technology Co., Ltd**
**Jingmen, Hubei 448000 (CN)**

(72) Inventors:
- **ZOU, Yingquan**
  **Beijing 100875 (CN)**
- **GUO, Yejia**
  **Beijing 100875 (CN)**
- **WANG, Zheng**
  **Beijing 100875 (CN)**
- **PANG, Yulian**
  **Beijing 100875 (CN)**

(74) Representative: **Rippel, Hans Christoph**
**Patentanwälte**
**Isenbruck Bösl Hörschler PartG mbB**
**Eastsite One**
**Seckenheimer Landstrasse 4**
**68163 Mannheim (DE)**

(56) References cited:
**WO-A1-00/64955**
**WO-A1-2008/085513**
**WO-A1-2012/022390**
**CN-A- 101 643 525**
**CN-A- 102 391 406**
**CN-A- 105 924 553**
**JP-A- S59 175 483**
**JP-A- S60 134 234**
**JP-A- S61 120 822**
**JP-A- 2002 229 204**

- **Tamotsu Hashimoto ET AL: "Selective Vinyl Cationic Polymerization of Monomers with Two Cationically Polymerizable Groups. 11. p-Vinylphenyl Glycidyl Ether: An Epoxy-Functionalized Styrene*", , 1 October 1987 (1987-10-01), XP055770184, Retrieved from the Internet: URL:https://onlinelibrary.wiley.com/doi/abs/10.1002/pola.1987.080251018 [retrieved on 2021-01-29]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 8/00, C08F 12/24;**
**C08F 212/22, C08F 212/24;**
**C08F 212/24, C08F 212/22**

## Description

### Technical field

The present invention relates to a poly-p-hydroxystyrene epoxy resin as defined in claim 1. This resin can be used as a film-forming resin for a photoresist system. The present invention further relates to the preparation of poly-p-hydroxystyrene epoxy resins and the application thereof as film-forming resins in photoresist systems.

### Background art

Photoresists are etch-resistant film materials whose solubility changes under irradiation or radiation of a light source such as an ultraviolet light, an excimer laser, an electron beam, an ion beam, or an X-ray. Since their invention in the 1950s, photoresists have become the core process materials in the semiconductor industry and are widely used in the manufacture of integrated circuits and printed circuit boards. In the early 1990s, photoresists were also applied to the processing and manufacturing of LCD devices, and played an important role in promoting large-size, high-refinement and colorization for LCD panels. For the microelectronics manufacturing industry, photoresists also play a pivotal role in the fine processing from micron scale, submicron scale, deep-submicron scale to nano scale.

According to the solubility change of photoresists before and after exposure, they can be divided into positive photoresists and negative photoresists. The solubility of positive photoresists increases after exposure and development, while the solubility of negative photoresists decreases after exposure and development. In general, positive photoresists have the advantages of high resolution, strong resistance to dry etching, good heat resistance, easy glue removal, good contrast, etc., but are poor in adhesion and mechanical strength, and require a high cost. Negative photoresists have good adhesion to substrates, with acid and alkali resistance, and fast photospeed, but due to the cross-linking in the exposed area, the solubility is weakened, which causes easy deformation and swelling during development, thereby limiting the resolution thereof.

With the continuous development of electronic devices towards high integration and refinement, the requirements on the properties of photoresists such as resolution are also increasing. The lithography technology has experienced the development process from g-line (436nm) lithography, i-line (365nm) lithography, to KrF (deep-UV 248nm) lithography, ArF (deep-UV 193nm) lithography, and the next generation extreme ultraviolet (EUV 13.5nm) lithography, and the photoresists corresponding to respective exposure wavelengths have also emerged as the times require. The key formulation components in photoresists, such as film-forming resins, photoinitiators, and additives, also change accordingly, allowing the overall performance of the photoresists to better meet the process requirements.

Micro-Electro-Mechanical System (MEMS) is a miniaturized mechatronics and intelligent system that consists of three main components: a micro-sensor, a micro-actuator and a micro-power. The system size is generally in the micron scale or even smaller, and the internal structure size is in the micron scale or even nano scale. The miniaturized mechatronics system is of such advantages as miniaturization, intelligence, integration, multi-function and suitable for mass production, and has broad development prospect in the fields of military affairs, aerospace, information communication, biomedicine, automatic control, automobile industry, and the like.

The microstructure of MEMS devices is manufactured by a photolithography process. Unlike the manufacture of general integrated circuits that pursues a higher resolution, the manufacture of MEMS pursues a higher aspect ratio, which requires the photoresists for MEMS to have a certain thickness. In order to satisfy the desired MEMS product development, thick-film photoresists emerge as the times require. In general, thick-film photoresists need to have good photosensitivity and aspect ratio, and the coating thickness is usually required to be at least 10 microns. In the manufacture of MEMS, thick-film photoresists can be directly used as working parts of MEMS devices, or as sacrificial layer materials to make MEMS devices with membrane structure and cantilever structure, or as mask layers of wet etching, or as electroplating models to make three-dimensional MEMS devices of non-silicon materials. Therefore, with the continuous development of MEMS, it is very important to develop a thick-film photoresist suitable for MEMS manufacturing.

At present, the already commercialized thick-film positive photoresists mainly include positive photoresists of AZ series, positive photoresists of SJR3000 series, positive photoresists of Ma-p100 series and positive photoresists of SPR 220-7 series, etc., and the negative photoresists are mainly negative photoresists of SU-8 series produced by MicroChem Company, US.

The commercially available positive thick-film photoresists are mostly diazonaphthoquinone positive photoresists, which are mainly composed of a phenolic resin, a photosensitive compound diazonaphthoquinone and an organic solvent. Under ultraviolet light irradiation, the diazonaphthoquinone compound in the exposed area loses a molecular nitrogen via photolysis, and is converted into an indancarboxylic acid via Wolff rearrangement, allowing the photoresist film to be dissolved in the alkaline developing solution. In the non-exposed area, no photochemical reaction occurs, and the hydroxyl group of the phenolic resin and the diazonaphthoquinone compound together form a stable six-membered ring structure by hydrogen bonding, thereby inhibiting dissolution of the resin.

The SU-8 series photoresist is an epoxy resin photoresist. Due to its good chemical, optical and mechanical properties, it has become the most widely and commonly used thick photoresist in the MEMS field. The main components of the SU-8 photoresist include a bisphenol A type novolac epoxy resin, an organic solvent (γ-butyrolactone or cyclopentanone), and a small amount of a photoacid generator triarylsulfonium salt. When exposed, the triarylsulfonium salt absorbs photons and releases a strong acid, and during the post-baking process, the acid catalyzes the cationic polymerization and crosslinking in the epoxy group of the epoxy resin. The crosslinking reaction grows in chain form, which can quickly form a dense crosslinking network structure with large molecular weight, and this network structure is insoluble in the developer during the development process, thus can be preserved. In the non-exposed area, the photoacid generator cannot produce any acid, thus cannot catalyze the polymerization and crosslinking of the epoxy group, so that the resin is soluble in the developer during the development process.

The photosensitive principle of SU-8 series photoresist is based on the cationic photocuring of epoxy resin. As an important system in UV curing technology, cationic photocuring system is developing rapidly and compared with free radical photocuring system, its most significant advantage is that it is not inhibited by oxygen, so that the volume shrinkage is small upon curing, the curing reaction is not easy to terminate, can still continue after illumination is stopped, and the toxicity is also low. Due to these advantages, cationic photocurable materials are very suitable for use as a major component of thick-film photoresists.

At present, cationic photocuring systems mainly include vinyl ether systems, epoxy systems, and oxetane systems.

The main advantage of the vinyl ether cationic photocuring system is that the curing rate is very fast without any induction period, and it can be cured at normal temperature, but there are disadvantages such as poor stability, the viscosity is low, and it is not easy to form a thick film.

The oxetane photocuring system is a relatively new cationic photocuring system, which can be cured at room temperature with a low curing shrinkage and a rather complete curing, the bonding strength is high, with a lower viscosity than epoxy monomers, and there is an induction period in the curing process, which requires large exposure. At present, there are few types of monomers, and the price is relatively expensive.

The epoxy system is the most commonly used cationic photocuring system at present. Its monomers are rich in variety, low in price, good in adhesion, high in strength and high in viscosity after curing. Although the curing is greatly affected by environmental temperature and humidity, and the curing reaction rate is slow, such influence can be reduced by appropriate process conditions, which is more suitable for film-forming resins of thick-film photoresists. As an epoxy system, it mainly includes phenolic epoxy resins, its main characteristics are as described in the previous introduction to the SU-8 photoresist film-forming resin, and its shortcomings are as follows: phenolic resin is synthesized by polycondensation reaction, the degree of which is not easy to control, so that the product molecular weight distribution is wide, the product needs to be classified and screened, the process flow is complex, not easy to operate, and requires a high cost. If the molecular weight of the resin is not uniform, the dissolution in the developer will be uneven, which will affect the resolution of photoresists.

Another type of film-forming resins for photoresists is poly-p-hydroxystyrene and its derivatives, among which the most widely used is poly-p-hydroxystyrene whose hydroxyl group is completely or partially protected, and the groups commonly used as protecting groups are t-butyl carbonate, acetal, ketal, silyl, etc. Such type of photoresist is exactly a positive photoresist, whose imaging principle is as follows: in the exposed area, the acid generated by the acid generator is used to catalyze the decomposition of the film-forming resin, remove the protecting group, and is dissolved in the alkaline developer, while in the non-exposed area, the acid is not dissolved in the alkaline developer due to the presence of the protecting group. The imaging principle of the poly-p-hydroxystyrene negative photoresist is as follows: in the exposed region, the acid-catalyzed crosslinking agent is subjected to a crosslinking reaction with the film-forming resin, such that the resin is not dissolved in the developer in the exposed area, but is dissolved in the developer in the non-exposed area. However, there are only a few types of poly-p-hydroxystyrene negative photoresists that have been currently developed, and the obtained photoresists are not thick-film photoresists, but ordinary photoresists.

JP 2002-229204 A discloses poly-(p-hydroxystyrene) 2-glycidyl ether, a process for its preparation by addition of epichlorohydrin to poly-(p-hydroxystyrene) (Mw preferably 1,000 to 20,000) and its use for photosensitive resin compositions. The modification ratio of the obtained poly(p-hydroxystrene) modified with an oxirane compound is 1 to 50%. An exemplified process is carried out at 60°C in the presence of NaOH.

**Contents of the invention**

In view of the problems in the prior art, the inventors of the present invention conducted extensive and intensive research on the film-forming resins of photoresists, with the expectation of finding a new film-forming resin for use in cationic photocurable photoresists, which film-forming resin has the advantages of good ultraviolet light transmittance, large viscosity to form a thick film, fast photospeed, high resolution, and the like. The present inventors have found that the modified resin obtained by introducing the epoxy moiety into the poly-p-hydroxystyrene molecule can achieve the

above object. Specifically, with poly-p-hydroxystyrene as the main structure, said poly-p-hydroxystyrene itself is synthesized by a polyaddition reaction, a resin with high molecular weight and narrow molecular weight distribution can be obtained by a cation controlled active polymerization, and poly-p-hydroxystyrene also has a good ultraviolet light transmission. Said characteristics as high molecular weight, narrow molecular weight distribution, good ultraviolet light transmittance are all conductive to improving the resolution of photoresists. There are a large amount of benzene rings in the resin structure, and the rigidity of benzene rings allows the resin to have good anti-etching property. The epoxy group introduced into the resin can undergo cationic photopolymerization, the photospeed is fast and there is no oxygen inhibition, thus the polymerization reaction is not easily terminated, can be continued even in the dark, and a crosslinked network is easily formed in the exposed region, thereby obtaining a high resolution lithographic image. Another advantage of epoxy resin is the high viscosity, so the photoresist film obtained has good adhesion to the substrate, and a thick photoresist film can be obtained. Due to these advantages, the modified resin has a bright application prospect in the field of thick-film photoresists. The present invention is thus realized based on the foregoing findings.

Accordingly, it is an object of the present invention to provide a modified poly-p-hydroxystyrene resin containing an epoxy moiety. When used as a film-forming resin for a photoresist, the resin has such advantages as good ultraviolet light transmittance, high viscosity to form a thick film, fast photospeed, high resolution, and the like.

It is another object of the present invention is to provide a process for preparing a modified poly-p-hydroxystyrene resin containing an epoxy moiety of the present invention.

A further object of the present invention is the use of a modified poly-p-hydroxystyrene resin containing an epoxy moiety of the present invention as a film-forming resin in a photoresist.

A still further object of the present invention is a photoresist comprising a modified poly-p-hydroxystyrene resin containing an epoxy moiety of the present invention.

The technical solution for achieving the above objects of the present invention can be summarized as follows:

1. A polymer of formula (I):

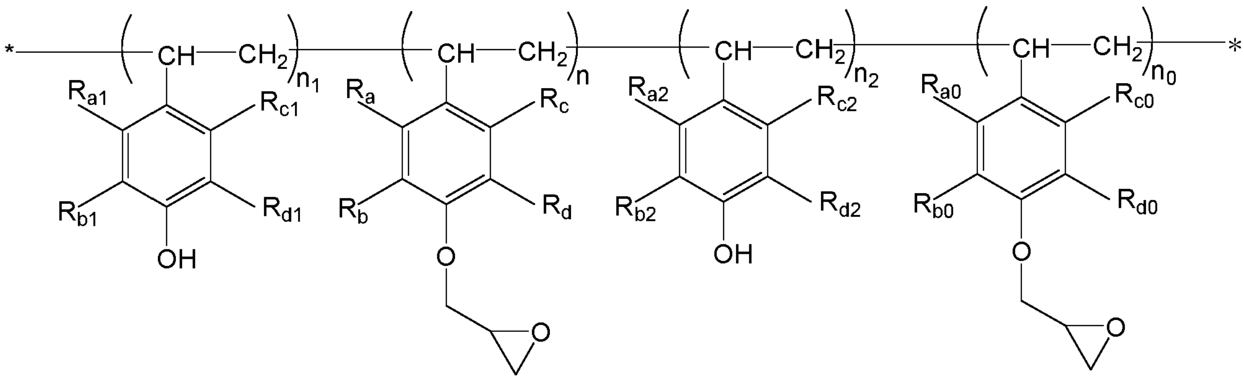

(I)

as defined in claim 1.

2. The polymer according to Item 1, wherein each of $R_a$-$R_d$, each of $R_{a0}$-$R_{d0}$, each of $R_{a1}$-$R_{d1}$, and each of $R_{a2}$-$R_{d2}$ are respectively independently selected from H, chloro, bromo, $C_1$-$C_4$ alkyl, chloro $C_1$-$C_4$ alkyl, bromo $C_1$-$C_4$ alkyl, $C_1$-$C_4$ alkoxy, chloro $C_1$-$C_4$ alkoxy and bromo $C_1$-$C_4$ alkoxy; preferably, $R_a$-$R_d$, $R_{a0}$-$R_{d0}$, $R_{a1}$-$R_{d1}$, and $R_{a2}$-$R_{d2}$ are all H.

3. The compound according to item 1 or 2, wherein n and $n_0$ are each independently a number from 0 to 40, preferably a number from 0 to 20, more preferably a number from 12 to 18, and n+$n_0$ is a number from 20 to 40, preferably a number from 24 to 36, more preferably a number from 25 to 30.

4. The polymer according to any one of items 1 to 3, wherein $n_1$ and $n_2$ are each independently a number from 0 to 2, preferably 0; and/or $n_1$+$n_2$ is a a number from 0 to 3, and more preferably 0.

5. A process for the preparation of a polymer of formula (I) according to any one of items 1 to 4, which comprises reacting a polymer of formula (II) with a compound of formula (III),

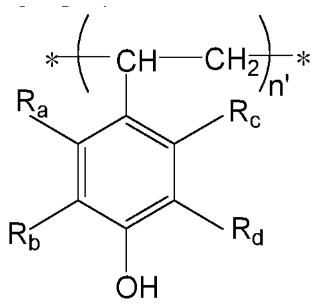

(II)

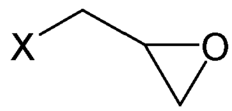

(III)

wherein $n'=n+n_0+n_1+n_2$, $R_a$-$R_d$, n, $n_0$, $n_1$ and $n_2$ are each as defined in any one of items 1 to 4, and X is a halogen, preferably chlorine or bromine;

wherein the reaction of the polymer of formula (II) with the compound of formula (III) is carried out in the presence of an alkaline catalyst, which is preferably one or more selected from the group consisting of NaOH, KOH, $Na_2CO_3$, $K_2CO_3$, more preferably $K_2CO_3$;
wherein the polymer of formula (II) and the compound of formula (III) are used in an amount such that the molar ratio of the monomer unit contained in the polymer of formula (II) to the compound of formula (III) is from 1:1 to 1:3, preferably from 1:1.8 to 1:2.0; and wherein the reaction of the polymer of formula (II) with the compound of formula (III) is carried out at 0-30°C, preferably at 25-30°C.

6. The process according to item 5, wherein the polymer of formula (II) and the alkaline catalyst are used in an amount such that the molar ratio of the monomer unit contained in the polymer of formula (II) to the alkaline catalyst is from 1:0.1 to 1:1, preferably from 1:0.6 to 1:1.
7. Use of a polymer of formula (I) according to any one of items 1 to 4 as a film-forming resin in a photoresist.
8. A photoresist comprising the polymer of formula (I) according to any one of items 1 to 4 as a film-forming resin.
9. The photoresist according to item 8, which comprises the polymer of formula (I) according to any one of items 1 to 4 as a film-forming resin, a photoacid generator, a photopolymerizable monomer, an alkaline additive, a sensitizer and a photoresist solvent; preferably, the mass ratio of the film-forming resin, photoacid generator, photopolymerizable monomer, alkaline additive, sensitizer, and photoresist solvent is (30-40): (1-4): (20-25): (1-2): (0-2): (40-50); more preferably, the mass ratio of the film-forming resin, photoacid generator, photopolymerizable monomer, alkaline additive, sensitizer, and photoresist solvent is 35:3.0:25: 1.5: 1.5:50.
10. The photoresist according to item 9, wherein the photoacid generator is any one or more of an iodonium salt, a sulfonium salt, and a heterocyclic acid generator; preferably the iodonium salt, sulfonium salt and heterocyclic acid generators are respectively of the formulae (IV), (V) and (VI):

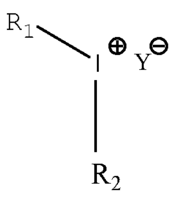

( IV)

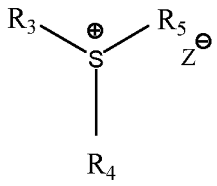

( V )

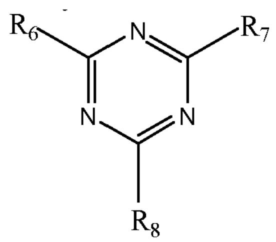

( VI)

wherein $R_1$, $R_2$, $R_3$, $R_4$, $R_5$, $R_6$, $R_7$ and $R_8$ are each independently phenyl, halophenyl, nitrophenyl, $C_6$ -$C_{10}$ aryl or $C_1$ -$C_{10}$ alkyl substituted benzoyl; and
Y, Z are non-nucleophilic anions such as triflate, $BF_4^-$, $ClO_4^-$, $PF_6^-$, $AsF_6^-$ or $SbF_6^-$.

11. The photoresist according to item 9 or 10, wherein

the photopolymerizable monomer is N-vinylpyrrolidone, hydroxyethyl methacrylate or a mixture thereof; and/or
the alkaline additive is a tertiary amine and/or a quaternary amine, more preferably any one or more of triethanolamine, trioctylamine and tributylamine; and/or
the sensitizer is any one or more of 2,4-diethylthioxanthone, 9-anthracene methanol and 1-[(2,4-dimethylphenyl)azo]-2-naphthol; and/or
the photoresist solvent is any one or more of cyclopentanone, γ-butyrolactone, and ethyl acetate.

**Description of figures**

Figure 1 is a lithographic image of the four photoresists obtained in Example 9; and
Figure 2 is a lithographic image of the four photoresists obtained in Example 10.

**Mode of carrying out the invention**

According to one aspect of the present invention, there is provided a polymer of the following formula (I):

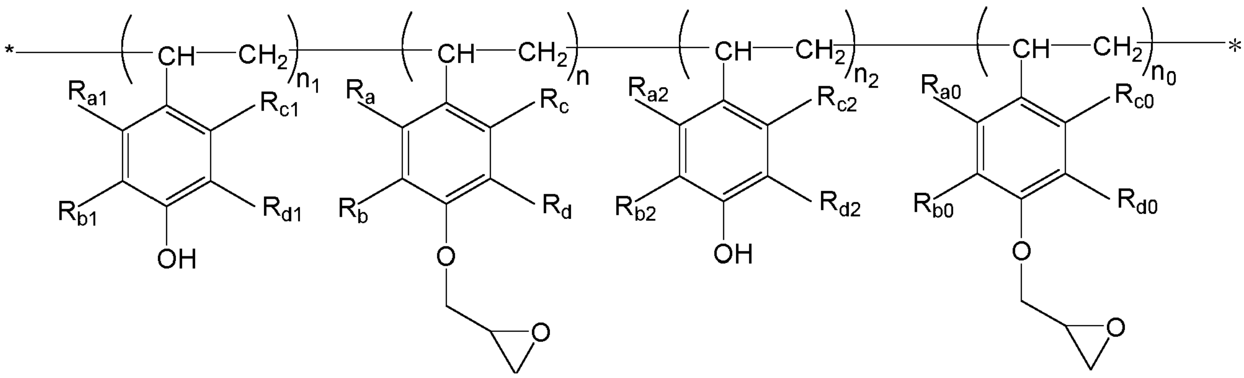

(I)

as defined in claim 1.

In the present invention, $R_a$-$R_d$, $R_{a0}$-$R_{d0}$, $R_{a1}$-$R_{d1}$ and $R_{a2}$-$R_{d2}$ are groups on the benzene ring. $R_a$-$R_d$ are the same or different, $R_{a0}$-$R_{a0}$ are the same or different, $R_{a1}$-$R_{d1}$ are the same or different, and $R_{a2}$-$R_{d2}$ are the same or different, and are each independently selected from H, halogen, $C_1$-$C_6$ alkyl, halo $C_1$-$C_6$ alkyl, $C_1$-$C_6$ alkoxy, halo $C_1$-$C_6$ alkoxy, $C_3$-$C_{12}$ cycloalkyl and halo $C_3$-$C_{12}$ cycloalkyl. Preferably, each of $R_a$-$R_d$, each of $R_{a0}$-$R_{d0}$, each of $R_{a1}$-$R_{d1}$, and each of $R_{a2}$-$R_{d2}$ are respectively independently selected from H, chloro, bromo, $C_1$-$C_4$ alkyl, chloro $C_1$-$C_4$ alkyl, bromo $C_1$-$C_4$ alkyl, $C_1$-$C_4$ alkoxy, chloro $C_1$-$C_4$ alkoxy and bromo $C_1$-$C_4$ alkoxy. More preferably, $R_a$-$R_d$, $R_{a0}$-$R_{d0}$, $R_{a1}$-$R_{d1}$, and $R_{a2}$-$R_{d2}$ are all H. In addition, $R_a$, $R_{a0}$, $R_{a1}$ and $R_{a2}$ may be the same or different, preferably the same. $R_b$, $R_{b0}$, $R_{b1}$ and $R_{b2}$ may be the same or different, preferably the same. $R_c$, $R_{c0}$, $R_{c1}$ and $R_{c2}$ may be the same or different, preferably the same. $R_d$, $R_{d0}$, Rai, and $R_{d2}$ may be the same or different, preferably the same.

In the present invention, n, $n_0$, $n_1$ and $n_2$ each independently represent the number of structural units in the poly-p-hydroxystyrene epoxy resin. n and $n_0$ are each independently a number from 0 to 40, preferably a number from 0 to 20, more preferably a number from 12 to 18. $n+n_0$ is usually a number from 20 to 40, preferably a number from 24 to 36, more preferably a number from 25 to 30. $n_1$ and $n_2$ are each independently a number from 0 to 2, preferably 0. $n_1+n_2$ is usually a number from 0 to 3, preferably 0.

According to another aspect of the present invention, there is also provided a process for the preparation of a polymer of the formula (I) according to the present invention, which comprises reacting a polymer of formula (II) with a compound of formula (III),

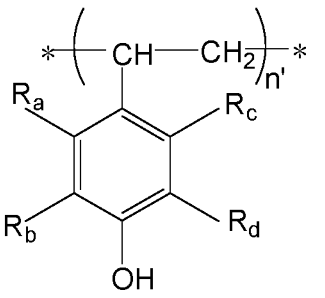

(II)

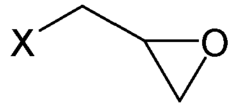

(III)

as defined in claim 5.

In the present invention, the reaction of the polymer of formula (II) with the compound of formula (III) is carried out in the presence of an alkaline catalyst. There is no particular limitation on the selection of the alkaline catalyst. Preferably, the alkaline catalyst is one or more of NaOH, KOH, $Na_2CO_3$, $K_2CO_3$. More preferably, the alkaline catalyst is $K_2CO_3$. In the present invention, the reaction of the polymer of formula (II) with the compound of formula (III) is not particularly limited with respect to the amount of the alkaline catalyst. Preferably, the polymer of formula (II) and the alkaline catalyst are used in an amount such that the molar ratio of the monomer unit contained in the polymer of formula (II) to the alkaline catalyst is from 1:0.1 to 1:1. More preferably, the polymer of formula (II) and the alkaline catalyst are used in an amount such that the molar ratio of the monomer unit contained in the polymer of formula (II) to the alkaline catalyst is from 1:0.6 to 1:1.

In the present invention, the reaction of the polymer of formula (II) with the compound of formula (III) shall generally ensure that the polymer of formula (II) is thoroughly reacted. Thus, the polymer of formula (II) and the compound of formula (III) are used in an amount such that the molar ratio of the monomer unit contained in the polymer of formula (II) to the compound of formula (III) is from 1:1 to 1:3. Preferably, the polymer of formula (II) and the compound of formula (III) are used in an amount such that the molar ratio of the monomer unit contained in the polymer of formula (II) to the compound of formula (III) is from 1:1.8 to 1:2.0.

In the present invention, the reaction of the polymer of formula (II) with the compound of formula (III) is usually carried out in a solution. There is no particular limitation on the selection of the solvent as long as each reactant can be dissolved. Advantageously, the reaction of the polymer of formula (II) with the compound of formula (III) is carried out in the presence of an organic solvent. Preferably, the organic solvent is one or more selected from the group consisting of ethanol, acetone, ethyl acetate, dichloromethane, and trichloromethane. More preferably, the organic solvent is one selected from the group consisting of ethanol and acetone.

In the present invention, the reaction conditions such as pressure required for the reaction of the polymer of formula (II) with the compound of formula (III) are conventional. The reaction is carried out at 0-30°C. Preferably, the reaction is carried out at 25-30°C. The reaction time is advantageously from 8 to 10 hours. The reaction pressure is advantageously atmospheric.

The product prepared is subjected to infrared characterization to observe whether the hydroxyl peaks in the vicinity of 3500 $cm^{-1}$ in the infrared spectrum are weakened or even disappeared or whether there is introduction of epoxy groups, thereby judging whether the polymer of formula (I) according to the present invention is obtained, and the structure of the product is confirmed by $^1H$-NMR.

By way of example, the preparation of a polymer of formula (I) by the reaction of a polymer of formula (II) with a compound of formula (III) can generally be carried out as follows:

Step 1): a polymer of formula (II) is mixed with an alkaline catalyst in a solvent to obtain a mixture;
Step 2): a compound of formula (III) is slowly added dropwise to the mixture obtained in Step 1) for reaction; and
Step 3): after completion of the reaction, it is filtered, the solvent and excess reactant are distilled off under reduced pressure to give a solid, which is washed, filtered, and dried to give a polymer of formula (I).

The operation of Step 1) can be carried out as follows: a polymer of formula (II) is first added into a solvent, stirred, nitrogen gas is introduced, and then an alkaline catalyst is added to obtain a mixture.

The operation of Step 2) can be carried out as follows: a compound of formula (III) is slowly added dropwise at 25-30°C to the mixture obtained in Step 1), and the reaction is carried out for 8-10 hours.

The operation of Step 3) can be carried out as follows: after completion of the reaction, the undissolved alkaline catalyst and the produced inorganic salt are removed by filtration, the filtrate is distilled under reduced pressure, the solvent and the excess compound of formula (III) are distilled off to obtain a solid, which is washed with water, filtered,

and dried to obtain a polymer of formula (I).

According to still another aspect of the present invention, there is provided the use of a polymer of formula (I) according to the present invention as a film-forming resin in a photoresist. When the polymer of formula (I) according to the present invention is used as a film-forming resin for a photoresist, with poly-p-hydroxystyrene as the main structure, said polypara-hydroxystyrene itself is synthesized by a polyaddition reaction, a resin with high molecular weight and narrow molecular weight distribution can be obtained by a cation controlled active polymerization, and poly-p-hydroxystyrene also has a good ultraviolet light transmission. Said characteristics as high molecular weight, narrow molecular weight distribution, good ultraviolet light transmittance are all conducive to improving the resolution of photoresists. There are a large amount of benzene rings in the resin structure, and the rigidity of benzene rings allows the resin to have good anti-etching property. The epoxy group introduced into the resin can undergo cationic photopolymerization, the photospeed is fast and there is no oxygen inhibition, thus the polymerization reaction is not easily terminated, can be continued even in the dark, and a crosslinked network is easily formed in the exposed region, thereby obtaining a high resolution lithographic image. Another advantage of epoxy resin is the high viscosity, so the photoresist film obtained has good adhesion to the substrate, and a thick photoresist film can be obtained.

According to the final aspect of the present invention, there is provided a photoresist comprising the polymer of formula (I) according to claim 1 as a film-forming resin.

In general, the photoresist of the present invention consists substantially of the following components: a polymer of formula (I) according to claim 1 as a film-forming resin, a photoacid generator, a photopolymerizable monomer, an alkaline additive, a sensitizer and a photoresist solvent. Preferably, the mass ratio of the film-forming resin, photoacid generator, photopolymerizable monomer, alkaline additive, sensitizer, and photoresist solvent is (30-40): (1-4): (20-25): (1-2): (0-2): (40-50). More preferably, the mass ratio of the film-forming resin, photoacid generator, photopolymerizable monomer, alkaline additive, sensitizer, and photoresist solvent is 35:3.0:25:1.5:1.5:50. By "substantially" herein is meant that at least 90% by weight, more preferably at least 95% by weight, especially at least 98% by weight, in particular at least 99% by weight, of the total weight of the photoresist is composed of a polymer of formula (I) as a film-forming resin, a photoacid generator, a photopolymerizable monomer, an alkaline additive, a sensitizer and a photoresist solvent.

In the present invention, the photoresist film-forming resin is any one or more of the polymers of formula (I) as defined in claim 1.

It is preferred according to the present invention that the photoacid generator is any one or more of an iodonium salt, a sulfonium salt, and a heterocyclic acid generator. Advantageously, the iodonium salt, sulfonium salt and heterocyclic acid generators are respectively of the formulae (IV), (V) and (VI):

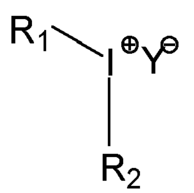

(IV)

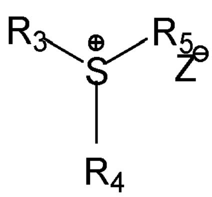

(V)

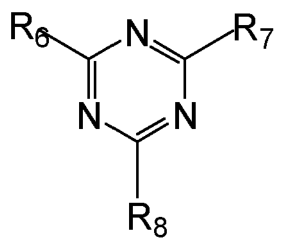

(VI)

wherein

$R_1$, $R_2$, $R_3$, $R_4$, $R_5$, $R_6$, $R_7$ and $R_8$ are each independently phenyl, halophenyl, nitrophenyl, $C_6$-$C_{10}$ aryl or $C_1$-$C_{10}$ alkyl substituted benzoyl; and

Y, Z are non-nucleophilic anions such as triflate, $BF_4^-$, $ClO_4^-$, $PF_6^-$, $AsF_6^-$ or $SbF_6^-$.

It is preferred according to the present invention that the photopolymerizable monomer is N-vinylpyrrolidone, hydroxyethyl methacrylate or a mixture thereof

It is preferred according to the present invention that the alkaline additive is a tertiary amine and/or a quaternary amine, more preferably any one or more of triethanolamine, trioctylamine and tributylamine.

It is preferred according to the present invention that the sensitizer is a sensitizer sensitive to a specific wavelength, e.g., any one or more of 2,4-diethylthioxanthone, 9-anthracene methanol and 1-[(2,4-dimethylphenyl)azo]-2-naphthol.

It is preferred according to the present invention that the photoresist solvent is any one or more of cyclopentanone, γ-butyrolactone, and ethyl acetate.

The polymer of formula (I) according to claim 1 has the following beneficial effects as a film-forming resin of

photoresists: with poly-p-hydroxystyrene as the main structure, said poly-p-hydroxystyrene itself is synthesized by a polyaddition reaction, a resin with high molecular weight and narrow molecular weight distribution can be obtained by a cation controlled active polymerization, and poly-p-hydroxystyrene also has a good ultraviolet light transmission. Said characteristics as high molecular weight, narrow molecular weight distribution, good ultraviolet light transmittance are all conducive to improving the resolution of photoresists. There are a large amount of benzene rings in the resin structure, and the rigidity of benzene rings allows the resin to have good anti-etching property. In particular, compared with other photoresist film-forming resins with poly-p-hydroxystyrene as the main structure, the film-forming resin of the present invention - as set out in the appended set of claims - has introduced an epoxy group, which can undergo cationic photopolymerization, the photospeed is fast and there is no oxygen inhibition, thus the polymerization reaction is not easily terminated, can be continued even in the dark, and a crosslinked network is easily formed in the exposed region, thereby obtaining a high resolution lithographic image. Another advantage of epoxy resin is the high viscosity, so the photoresist film obtained has good adhesion to the substrate, and a thick photoresist film can be obtained.

Examples

The characterization and detection methods involved in the following examples are as follows:

1. Infrared spectroscopy characterization method

The infrared spectrum was measured by IRAffinity Fourier Transform Infrared Spectrometer, Shimadzu Corporation, with a scanning range of 4000-400 $cm^{-1}$, and the sample was processed by a KBr tableting method.

2. $^1H$ NMR spectrum characterization method

$^1H$ NMR was measured by a Bruker Avame PRX400 nuclear magnetic resonance apparatus, the chemical shift was expressed in ppm, the solvent was deuterated chloroform, the internal standard was tetramethylsilane, the scanning width was 400 MHz, and the number of scanning was 16 times.

3. Ultraviolet absorption spectrometry method

Using acetonitrile as a solvent, the sample was formulated into a solution having a concentration of 30 ppm, and the ultraviolet absorption spectrum was measured by a Shimadzu UV-2450 ultraviolet-visible spectrophotometer. The measurement range was 200-400 nm, the resolution was 0.1 nm, the spectrum width was 0.1-5 nm, and the stray light as 0.015% or less.

4. Epoxy value determination method

The epoxy value of the sample was measured by the hydrochloric acid-acetone method. 0.4g of sample was accurately weighed and added to a 250mL closed conical flask, after which 25mL of 0.2mol/L hydrochloric acid acetone solution was added, shaken to completely dissolve the sample, and after standing at room temperature for 2 h, 3 drops of phenolphthalein reagent were added, titrated with 0.1 mol/L sodium hydroxide-ethanol standard solution until the solution turned pink, and two blank titrations were carried out under the same conditions. The volume of the sodium hydroxide standard solution required for titration was recorded, and the epoxy value of the sample was calculated according to the formula (1).

$$E = \frac{(V_1 - V_2) \times c_{NaOH}}{10m} \qquad (1)$$

In the formula:

E - epoxy value, mol/100g;
Vi - the volume of sodium hydroxide-ethanol standard solution consumed by the blank experiment, mL;
$V_2$ - the volume of sodium hydroxide-ethanol standard solution consumed by the sample, mL; $c_{NaOH}$ - the concentration of sodium hydroxide-ethanol standard solution, mol/L;
m - mass of the sample, g.

**Example 1: Poly 4-(2',3'-glycidoxy)styrene**

50 ml of acetone was selected as solvent, to which 12 g of poly-p-hydroxystyrene (number average molecular weight of 3000, n'=25) (0.1 mol of repeating unit) was added, electrically stirred while introducing nitrogen, and 2.4 g (0.06 mol) of sodium hydroxide was added. The temperature of the reaction mixture obtained was controlled at 25°C, and 16.65 g of epichlorohydrin (0.18 mol) was slowly added dropwise through a constant pressure dropping funnel, and the dropwise addition was completed in 0.5 h, afterwards the resulting reaction mixture was reacted at 25°C for 8 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.

The nuclear magnetic data are as follows (d-$CDCl_3$): methylene of the polystyrene chain was at δ1.87; methylene of the epoxy ring was at δ2.50; methine of the polystyrene chain was at δ2.76; H of the benzene ring was at δ6.69,7.02; methylene of the glycidoxy group attached to oxygen was at δ4.07; methine of the epoxy ring was at δ3.04, and no hydroxyl signal was detected.

Infrared spectroscopy results: no hydroxyl stretching vibration peak was detected at 3100 $cm^{-1}$-3500 $cm^{-1}$, and a characteristic absorption peak of the epoxy ring was detected at 910 $cm^{-1}$.

Ultraviolet absorption spectrum results: the maximum absorption wavelength was 226 nm, with no ultraviolet absorption peak above 226 nm, and there was good light transmission in the ultraviolet light region above 226 nm.

Epoxy value measurement result: the epoxy value was 0.57 mol/100 g.

**Example 2: Poly 3,5-dimethyl-4-(2',3'-glycidoxy)styrene**

50 ml of ethanol was selected as solvent, to which 14.8 g of poly 3,5-dimethyl-4-hydroxystyrene (number average molecular weight of 2960, n'=20) (0.1 mol of repeating unit) was added, electrically stirred while introducing nitrogen, and 5.6 g (0.1 mol) of potassium hydroxide was added. The temperature of the reaction mixture obtained was controlled at 20°C, and 18.5 g of epichlorohydrin (0.2 mol) was slowly added dropwise through a constant pressure dropping funnel, and the dropwise addition was completed in 0.5 h, afterwards the resulting reaction mixture was reacted at 25°C for 8 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.

The nuclear magnetic data are as follows (d-$CDCl_3$): methylene of the polystyrene chain was at δ1.87; methyl was at δ2.34, methylene of the epoxy ring was at δ2.50; methine of the polystyrene chain was at δ2.76; H of the benzene ring was at δ6.63; methylene of the glycidoxy group attached to oxygen was at δ4.07; methine of the epoxy ring was at δ3.04, and no hydroxyl signal was detected.

Infrared spectroscopy results: no hydroxyl stretching vibration peak was detected at 3100 $cm^{-1}$-3500 $cm^{-1}$, and a characteristic absorption peak of the epoxy ring was detected at 911 $cm^{-1}$.

Ultraviolet absorption spectrum results: the maximum absorption wavelength was 219 nm, with no ultraviolet absorption peak above 219 nm, and there was good light transmission in the ultraviolet light region above 219 nm.

Epoxy value measurement result: the epoxy value was 0.49 mol/100 g.

**Example 3: Poly 3-ethoxy-4-(2',3'-glycidoxy)styrene**

50 ml of ethyl acetate was selected as solvent, to which 16.4 g of poly 3-ethoxy-4-hydroxystyrene (number average molecular weight of 4920, n=30) (0.1 mol of repeating unit) was added, electrically stirred while introducing nitrogen, and 8.28 g (0.06 mol) of potassium carbonate was added. The temperature of the reaction mixture obtained was controlled at 30°C, and 18.5 g of epichlorohydrin (0.2 mol) was slowly added dropwise through a constant pressure dropping funnel, and the dropwise addition was completed in 0.5 h, afterwards the resulting reaction mixture was reacted at 25°C for 10 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.

The nuclear magnetic data are as follows (d-$CDCl_3$): methylene of the polystyrene chain was at δ1.87; methyl was at δ1.33, methylene of the ethoxy group was at δ3.98; methylene of the epoxy ring was at δ2.50; methine of the polystyrene chain was at δ2.76; H of the benzene ring was at δ6.58,6.53; methylene of the glycidoxy group attached to oxygen was at δ4.07; methine of the epoxy ring was at δ3.04, and no hydroxyl signal was detected.

Infrared spectroscopy results: no hydroxyl stretching vibration peak was detected at 3100 $cm^{-1}$-3500 $cm^{-1}$, and a characteristic absorption peak of the epoxy ring was detected at 914 $cm^{-1}$.

Ultraviolet absorption spectrum results: the maximum absorption wavelength was 223 nm, with no ultraviolet absorption peak above 223 nm, and there was good light transmission in the ultraviolet light region above 223 nm.
Epoxy value measurement result: the epoxy value was 0.45 mol/100 g.

**Example 4: Poly 2-chloro-4-(2',3'-glycidoxy)styrene**

50 ml of ethyl acetate was selected as solvent, to which 15.5 g of poly 2-chloro-4-hydroxystyrene (number average molecular weight of 3887, n=25) (0.1 mol of repeating unit) was added, electrically stirred while introducing nitrogen, and 6.36 g (0.06 mol) of sodium carbonate was added. The temperature of the reaction mixture obtained was controlled at 30°C, and 16.65 g of epichlorohydrin (0.18 mol) was slowly added dropwise through a constant pressure dropping funnel, and the dropwise addition was completed in 0.5 h, afterwards the resulting reaction mixture was reacted at 30°C for 9 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.
The nuclear magnetic data are as follows (d-$CDCl_3$): methylene of the polystyrene chain was at $\delta$1.87; methine of the polystyrene chain was at $\delta$2.76; H of the benzene ring was at $\delta$ 6.57,6.70,6.96; methylene of the glycidoxy group attached to oxygen was at $\delta$4.07; methine of the epoxy ring was at $\delta$3.04; methylene of the epoxy ring was at $\delta$2.50, and no hydroxyl signal was detected.
Infrared spectroscopy results: no hydroxyl stretching vibration peak was detected at 3100 $cm^{-1}$-3500 $cm^{-1}$, and a characteristic absorption peak of the epoxy ring was detected at 914 $cm^{-1}$.
Ultraviolet absorption spectrum results: the maximum absorption wavelength was 217 nm, with no ultraviolet absorption peak above 217 nm, and there was good light transmission in the ultraviolet light region above 217 nm.
Epoxy value measurement result: the epoxy value was 0.47 mol/100 g.

**Example 5: Poly 2-chloromethyl-4-(2',3'-glycidoxy)styrene**

50 ml of dichloromethane was selected as solvent, to which 17 g of poly 2-chloromethyl-4-hydroxystyrene (number average molecular weight of 5055, n=30) (0.1 mol of repeating unit) was added, electrically stirred while introducing nitrogen, and 2.4 g (0.06 mol) of sodium hydroxide was added. The temperature of the reaction mixture obtained was controlled at 30°C, and 16.65 g of epichlorohydrin (0.18 mol) was slowly added dropwise through a constant pressure dropping funnel, and the dropwise addition was completed in 0.5 h, afterwards the resulting reaction mixture was reacted at 25°C for 8 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.
The nuclear magnetic data are as follows (d-$CDCl_3$): methylene of the polystyrene chain was at $\delta$1.87; methine of the polystyrene chain was at $\delta$2.76; H of the benzene ring was at $\delta$6.70,7.02; methylene of the glycidoxy group attached to oxygen was at $\delta$4.07; methine of the epoxy ring was at $\delta$3.04; chloromethyl was at $\delta$4.64; methylene of the epoxy ring was at $\delta$2.50; and a weak hydroxyl peak was detected at $\delta$5.07.
Infrared spectroscopy results: a weak hydroxyl stretching vibration peak was detected at 3100 $cm^{-1}$-3500 $cm^{-1}$, and a characteristic absorption peak of the epoxy ring was detected at 914 $cm^{-1}$.
Ultraviolet absorption spectrum results: the maximum absorption wavelength was 224 nm, with no ultraviolet absorption peak above 224 nm, and there was good light transmission in the ultraviolet light region above 224 nm.
Epoxy value measurement result: the epoxy value was 0.40 mol/100 g.

**Example 6: Poly 2-methyl-5-methoxy-4-(2',3'-glycidoxy)styrene**

50 ml of acetone was selected as solvent, to which 16.4 g of poly 2-methyl-5-methoxy-4-hydroxystyrene (number average molecular weight of 5740, n=35) (0.1 mol of repeating unit) was added, electrically stirred while introducing nitrogen, and 11.04 g (0.08 mol) of potassium carbonate was added. The temperature of the reaction mixture obtained was controlled at 30°C, and 17.58 g of epichlorohydrin (0.19 mol) was slowly added dropwise through a constant pressure dropping funnel, and the dropwise addition was completed in 0.5 h, afterwards the resulting reaction mixture was reacted at 25°C for 8 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.
The nuclear magnetic data are as follows (d-$CDCl_3$): methylene of the polystyrene chain was at $\delta$1.87; methine

of the polystyrene chain was at δ2.76; H of the benzene ring was at δ6.38,6.41; methylene of the glycidoxy group attached to oxygen was at δ4.07; methine of the epoxy ring was at δ3.04; methyl was at δ2.35; methoxy was at δ3.73; methylene of the epoxy ring was at δ2.50, and a weak hydroxyl peak was detected at δ5.03.

Infrared spectroscopy results: a weak hydroxyl stretching vibration peak was detected at 3100 $cm^{-1}$-3500 $cm^{-1}$, and a characteristic absorption peak of the epoxy ring was detected at 910 $cm^{-1}$.

Ultraviolet absorption spectrum results: the maximum absorption wavelength was 218 nm, with no ultraviolet absorption peak above 218 nm, and there was good light transmission in the ultraviolet light region above 218 nm.

Epoxy value measurement result: the epoxy value was 0.40 mol/100 g.

**Example 7: Poly 3-cyclopropyl-4-(2',3'-glycidoxy)styrene**

50 ml of acetone was selected as solvent, to which 16.1 g of poly 3-cyclopropyl-4-hydroxystyrene (number average molecular weight of 6440, n=40) (0.1 mol of repeating unit) was added, electrically stirred while introducing nitrogen, and 4.2 g (0.075 mol) of potassium hydroxide was added. The temperature of the reaction mixture obtained was controlled at 30°C, and 17.58 g of epichlorohydrin (0.19 mol) was slowly added dropwise through a constant pressure dropping funnel, and the dropwise addition was completed in 0.5 h, afterwards the resulting reaction mixture was reacted at 25°C for 9 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.

The nuclear magnetic data are as follows (d-$CDCl_3$): methylene of the polystyrene chain was at δ1.87; methine of the polystyrene chain was at δ2.76; H of the benzene ring was at δ6.89,6.84,6.61; methylene of the glycidoxy group attached to oxygen was at δ4.07; methine of the epoxy ring was at δ3.04; methylene of the epoxy ring was at δ2.50, methine of the cyclopropyl group was at δ1.51; methylene of the cyclopropyl group was at δ0.51, and a very small hydroxyl peak was detected at δ5.41.

Infrared spectroscopy results: a weak hydroxyl stretching vibration peak was detected at 3100 $cm^{-1}$-3500 $cm^{-1}$, and a characteristic absorption peak of the epoxy ring was detected at 912 $cm^{-1}$.

Ultraviolet absorption spectrum results: the maximum absorption wavelength was 226 nm, with no ultraviolet absorption peak above 226 nm, and there was good light transmission in the ultraviolet light region above 226 nm.

Epoxy value measurement result: the epoxy value was 0.42 mol/100 g.

**Example 8: Poly 2-chloro-5-ethoxy-4-(2',3'-glycidoxy)styrene**

50 ml of ethanol was selected as solvent, to which 19.85 g of poly 2-chloro-5-ethoxy-4-hydroxystyrene (number average molecular weight 6948, n=35) (0.1 mol of repeating unit) was added, electrically stirred while introducing nitrogen, and 8.48 g (0.08 mol) of sodium carbonate was added. The temperature of the reaction mixture obtained was controlled at 30°C, and 18.5 g of epichlorohydrin (0.2 mol) was slowly added dropwise through a constant pressure dropping funnel, and the dropwise addition was completed in 0.5 h, afterwards the resulting reaction mixture was reacted at 25°C for 10 h. After completion of the reaction, the undissolved inorganic material was filtered off, the filtrate was distilled under reduced pressure, the solvent and the excess epichlorohydrin were distilled off to obtain a solid, which was washed three times with water, filtered, and dried to obtain a product, which was shown to be the title polymer according to analysis.

The nuclear magnetic data are as follows (d-$CDCl_3$): methylene of the polystyrene chain was at δ1.87; methine of the polystyrene chain was at δ2.76; H of the benzene ring was at δ6.47,6.59; methylene of the glycidoxy group attached to oxygen was at δ4.07; methine of the epoxy ring was at δ3.04; methylene of the epoxy ring was at δ2.50; methyl of the ethoxy group was at δ1.33; methylene of the ethoxy group was at δ3.98; and a weak hydroxyl peak was detected at δ5.13.

Infrared spectroscopy results: a weak hydroxyl stretching vibration peak was detected at 3100 $cm^{-1}$-3500 $cm^{-1}$, and a characteristic absorption peak of the epoxy ring was detected at 909 $cm^{-1}$.

Ultraviolet absorption spectrum results: the maximum absorption wavelength was 220 nm, with no ultraviolet absorption peak above 220 nm, and there was good light transmission in the ultraviolet light region above 220 nm.

Epoxy value measurement result: the epoxy value was 0.37 mol/100 g.

**Example 9**

Four negative chemically amplified photoresists were prepared as follows: 30 g of each of the polymers prepared in Examples 1-4, 2 g of 3-nitrophenyl diphenylthio hexafluorophosphate, 25 g of N-vinylpyrrolidone, 1.8 g of trioctylamine, 1 g of 9-anthracene methanol and 50 g of ethyl acetate were respectively weighed, the above materials were mixed and thoroughly stirred to completely dissolve, and filtered through a 0.45 μm polytetrafluoroethylene microporous filter mem-

brane, thereby obtaining four new negative chemically amplified photoresists.

**Example 10**

Four negative chemically amplified photoresists were prepared as follows: 40 g of each of the polymers prepared in Examples 5-8, 3 g of bis(4-tert-butylphenyl)iodotrifluoromethanesulfonate, 20 g of hydroxyethyl methacrylate, 1.5 g of triethanolamine, 1.5 g of 2,4-diethylthioxanthone and 50 g of cyclopentanone were respectively weighed, the above materials were mixed and thoroughly stirred to completely dissolve, and filtered through a 0.45 μm polytetrafluoroethylene microporous filter membrane, thereby obtaining four new negative chemically amplified photoresists.

**Example 11**

The four negative chemically amplified photoresists obtained in the above Example 9 were respectively coated on a 6-inch single crystal silicon wafer by spin coating (rotation speed: 4000 rpm), baked at 90°C for 2 minutes, and cooled to room temperature, after which the coated silicon wafer was exposed in an exposure machine having a wavelength of 365 nm, baked at 110°C for 2 minutes after exposure, and developed with a propylene glycol methyl ether acetate aqueous solution as a developing solution for 60 s to obtain a lithographic image. The lithographic images of the photoresists obtained by the polymers from Examples 1-4 are shown in Figures 1(a)-(d), respectively.

**Example 12**

The four negative chemically amplified photoresists obtained in the above Example 10 were respectively coated on a 6-inch single crystal silicon wafer by spin coating (rotation speed: 4000 rpm), baked at 100°C for 2 minutes, and cooled to room temperature, after which the coated silicon wafer was exposed in an exposure machine having a wavelength of 248 nm, baked at 100°C for 2 minutes after exposure, and developed with a propylene glycol methyl ether acetate aqueous solution as a developing solution for 50 s to obtain a lithographic image. The lithographic images of the photoresists obtained by the polymers from Examples 5-8 are shown in Figures 2(a)-(d), respectively.

As can be seen from Figure 1, by using the polymers from Examples 1-4 as film-forming resins, the formulated photoresists are subjected to such procedure as exposure and development, thereby obtaining a clear image with a diameter of about 30 μm, the image has a high resolution, regular pattern arrangement, complete edge, and no glue drop-off or residue phenomenon.

As can be seen from Figure 2, by using the polymers from Examples 5-8 as film-forming resins, the formulated photoresists are subjected to such procedure as exposure and development, thereby obtaining thick photoresist films, the sidewall of the image is steep, the height is up to 70 μm, and the aspect ratio may be up to 1:1.

The polymers prepared in the above Examples are used for negative chemically amplified photoresists. Based on the cationic photocuring of epoxy groups, a chemical amplification technology is adopted, and with polyhydroxystyrene as the main structure, such characteristics as high molecular weight, narrow molecular weight distribution, good ultraviolet light transmittance allow the photoresists to have a favorable resolution. The introduction of the epoxy structure makes it possible for the resin to easily form a crosslinked network in the exposed area, thereby obtaining a high-resolution lithographic image; in addition, the high viscosity of the epoxy resin allows the obtained photoresist film to have good adhesion to the substrate, so that a thick photoresist film can be easily obtained, and after its exposure and development, a clear image with a diameter of 30 μm and a thickness of up to 70 μm can be easily obtained, thus having a bright application prospect in the field of thick-film photoresists.

## Claims

1. A polymer of formula (I)

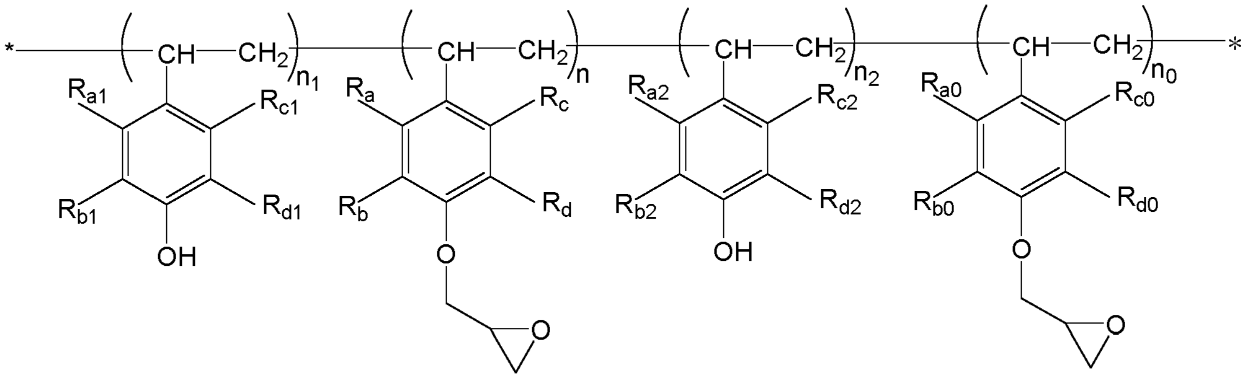

(I)

wherein :

each of $R_a$-$R_d$, each of $R_{a0}$-$R_{d0}$, each of $R_{a1}$-$R_{d1}$, and each of $R_{a2}$-$R_{d2}$ are respectively independently selected from the group consisting of H, halogen, $C_1$-$C_6$ alkyl, halo $C_1$-$C_6$ alkyl, $C_1$-$C_6$ alkoxy, halo $C_1$-$C_6$ alkoxy, $C_3$-$C_{12}$ cycloalkyl and halo $C_3$-$C_{12}$ cycloalkyl;
n and $n_0$ are each independently a number from 0 to 40, and $n+n_0$ is a number from 20 to 40; and
$n_1$ and $n_2$ are each independently a number from 0 to 2, and/or $n_1+n_2$ is a number from 0 to 3;
obtainable by a process which comprises reacting a polymer of formula (II) with a compound of formula (III),

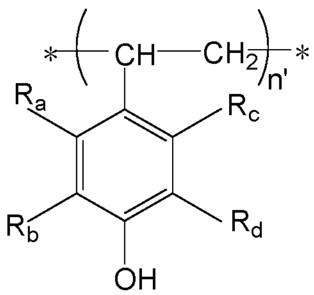

(II)

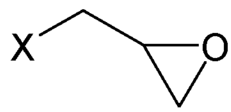

(III)

wherein $n'=n+n_0+n_1+n_2$, $R_a$-$R_d$, n, $n_0$, $n_1$ and $n_2$ are each as defined_above, and X is a halogen, preferably chlorine or bromine,

wherein the reaction of the polymer of formula (II) with the compound of formula (III) is carried out in the presence of an alkaline catalyst, which is preferably one or more selected from the group consisting of NaOH, KOH, $Na_2CO_3$, $K_2CO_3$, more preferably $K_2CO_3$,
wherein the polymer of formula (II) and the compound of formula (III) are used in an amount such that the molar ratio of the monomer unit contained in the polymer of formula (II) to the compound of formula (III) is from 1:1 to 1:3, preferably from 1:1.8 to 1:2.0; and
wherein the reaction of the polymer of formula (II) with the compound of formula (III) is carried out at 0-30°C, preferably at 25-30°C.

**2.** The polymer according to claim 1, wherein each of $R_a$-$R_d$, each of $R_{a0}$-$R_{d0}$, each of $R_{a1}$-$R_{d1}$, and each of $R_{a2}$-$R_{d2}$ are respectively independently selected from H, chloro, bromo, $C_1$-$C_4$ alkyl, chloro $C_1$-$C_4$ alkyl, bromo $C_1$-$C_4$ alkyl, $C_1$-$C_4$ alkoxy, chloro $C_1$-$C_4$ alkoxy and bromo $C_1$-$C_4$ alkoxy; preferably, $R_a$-$R_d$, $R_{a0}$-$R_{d0}$, $R_{a1}$-$R_{d1}$, and $R_{a2}$-$R_{d2}$ are all H.

**3.** The compound according to claim 1 or 2, wherein n and $n_0$ are each independently a number from 0 to 20, preferably a number from 12 to 18, and $n+n_0$ is a number from 24 to 36, preferably a number from 25 to 30.

**4.** The polymer according to any one of claims 1 to 3, wherein $n_1$ and $n_2$ are each independently 0; and/or $n_1+n_2$ is 0.

**5.** A process for the preparation of a polymer of formula (I) according to any one of claims 1 to 4, which comprises reacting a polymer of formula (II) with a compound of formula (III),

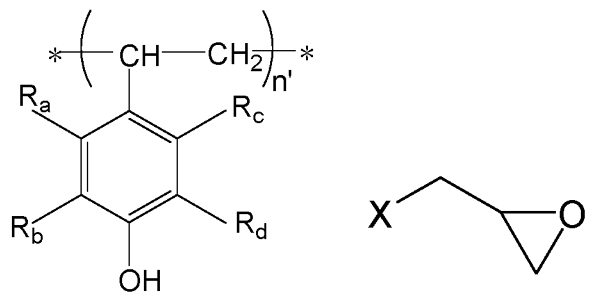

(II) (III)

wherein $n'=n+n_0+n_1+n_2$, $R_a$-$R_d$, n, $n_0$, $n_1$ and $n_2$ are each as defined in any one of claims 1 to 4, and X is a halogen, preferably chlorine or bromine;
wherein the reaction of the polymer of formula (II) with the compound of formula (III) is carried out in the presence of an alkaline catalyst, which is preferably one or more selected from the group consisting of NaOH, KOH, $Na_2CO_3$, $K_2CO_3$, more preferably $K_2CO_3$;
wherein the polymer of formula (II) and the compound of formula (III) are used in an amount such that the molar ratio of the monomer unit contained in the polymer of formula (II) to the compound of formula (III) is from 1:1 to 1:3, preferably from 1:1.8 to 1:2.0; and

wherein the reaction of the polymer of formula (II) with the compound of formula (III) is carried out at 0-30°C, preferably at 25-30°C.

**6.** The process according to claim 5, wherein the polymer of formula (II) and the alkaline catalyst are used in an amount such that the molar ratio of the monomer unit contained in the polymer of formula (II) to the alkaline catalyst is from 1:0.1 to 1:1, preferably from 1:0.6 to 1:1.

**7.** Use of a polymer of formula (I) according to any one of claims 1 to 4 as a film-forming resin in a photoresist.

**8.** A photoresist comprising a_polymer of formula (I)

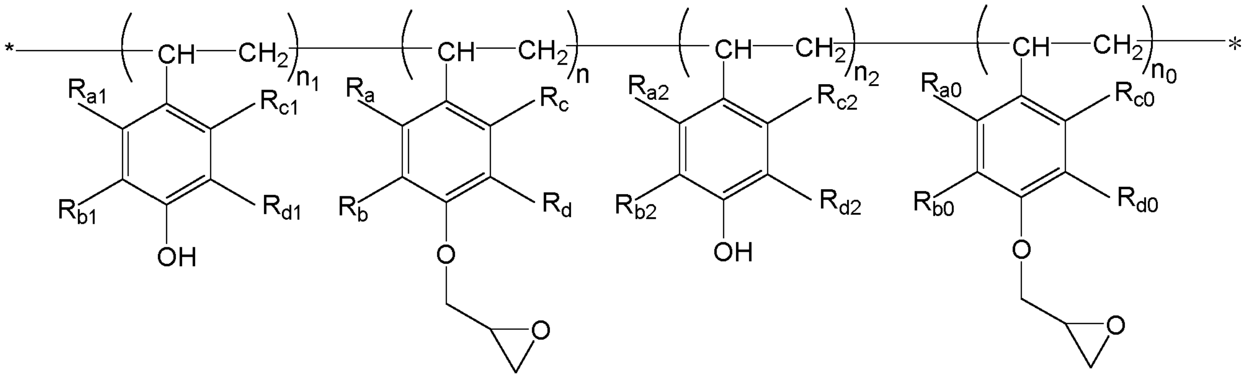

(I)

wherein :

each of $R_a$-$R_d$, each of $R_{a0}$-$R_{d0}$, each of $R_{a1}$-$R_{d1}$, and each of $R_{a2}$-$R_{d2}$ are respectively independently selected from the group consisting of H, halogen, $C_1$-$C_6$ alkyl, halo $C_1$-$C_6$ alkyl, $C_1$-$C_6$ alkoxy, halo $C_1$-$C_6$ alkoxy, $C_3$-$C_{12}$

cycloalkyl and halo $C_3$-$C_{12}$ cycloalkyl;

n and $n_0$ are each independently a number from 0 to 40, and $n+n_0$ is a number from 20 to 40; and

$n_1$ and $n_2$ are each independently a number from 0 to 2, preferably 0; and/or $n_1+n_2$ is a number from 0 to 3, and preferably 0,

as a film-forming resin.

**9.** The photoresist according to claim 8 wherein each of $R_a$-$R_d$, each of $R_{a0}$-$R_{d0}$, each of $R_{a1}$-$R_{d1}$, and each of $R_{a2}$-$R_{d2}$ are respectively independently selected from H, chloro, bromo, $C_1$-$C_4$ alkyl, chloro $C_1$-$C_4$ alkyl, bromo $C_1$-$C_4$ alkyl, $C_1$-$C_4$ alkoxy, chloro $C_1$-$C_4$ alkoxy and bromo $C_1$-$C_4$ alkoxy; preferably, $R_a$-$R_d$, $R_{a0}$-$R_{d0}$, $R_{a1}$-$R_{d1}$, and $R_{a2}$-$R_{d2}$ are all H.

**10.** The photoresist according to claim 8 or 9 wherein n and $n_0$ are each independently usually a number from 0 to 20, preferably a number from 12 to 18, and $n+n_0$ is a number from 24 to 36, preferably a number from 25 to 30.

**11.** The photoresist according to any of claims 8 to 10, which comprises the polymer of formula (I) according to any one of claims 8 to 10_as a film-forming resin, a photoacid generator, a photopolymerizable monomer, an alkaline additive, a sensitizer and a photoresist solvent; preferably, the mass ratio of the film-forming resin, photoacid generator, photopolymerizable monomer, alkaline additive, sensitizer, and photoresist solvent is (30-40): (1-4): (20-25): (1-2): (0-2): (40-50); more preferably, the mass ratio of the film-forming resin, photoacid generator, photopolymerizable monomer, alkaline additive, sensitizer, and photoresist solvent is 35:3.0:25:1.5:1.5:50.

**12.** The photoresist according to claim 11, wherein the photoacid generator is any one or more of an iodonium salt, a sulfonium salt, and a heterocyclic acid generator; preferably the iodonium salt, sulfonium salt and heterocyclic acid generators are respectively of the formulae (IV), (V) and (VI):

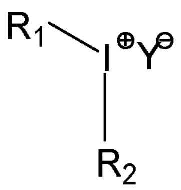
(IV)

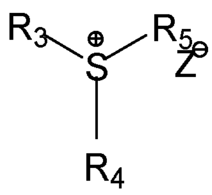
(V)

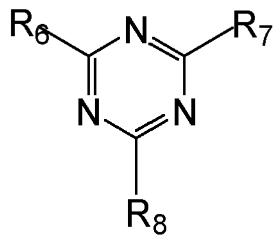
(VI)

wherein $R_1$, $R_2$, $R_3$, $R_4$, $R_5$, $R_6$, $R_7$ and $R_8$ are each independently phenyl, halophenyl, nitrophenyl, $C_6$ -$C_{10}$ aryl or $C_1$ -$C_{10}$ alkyl substituted benzoyl; and

Y, Z are non-nucleophilic anions such as triflate, $BF_4^-$, $ClO_4^-$, $PF_6^-$, $AsF_6^-$ or $SbF_6^-$.

**13.** The photoresist according to claim 11 or 12, wherein

the photopolymerizable monomer is N-vinylpyrrolidone, hydroxyethyl methacrylate or a mixture thereof; and/or
the alkaline additive is a tertiary amine and/or a quaternary amine, more preferably any one or more of triethanolamine, trioctylamine and tributylamine; and/or
the sensitizer is any one or more of 2,4-diethylthioxanthone, 9-anthracene methanol and 1-[(2,4-dimethylphenyl)azo]-2-naphthol; and/or

the photoresist solvent is any one or more of cyclopentanone, $\gamma$-butyrolactone, and ethyl acetate.

## Patentansprüche

**1.** Ein Polymer der Formel (I)

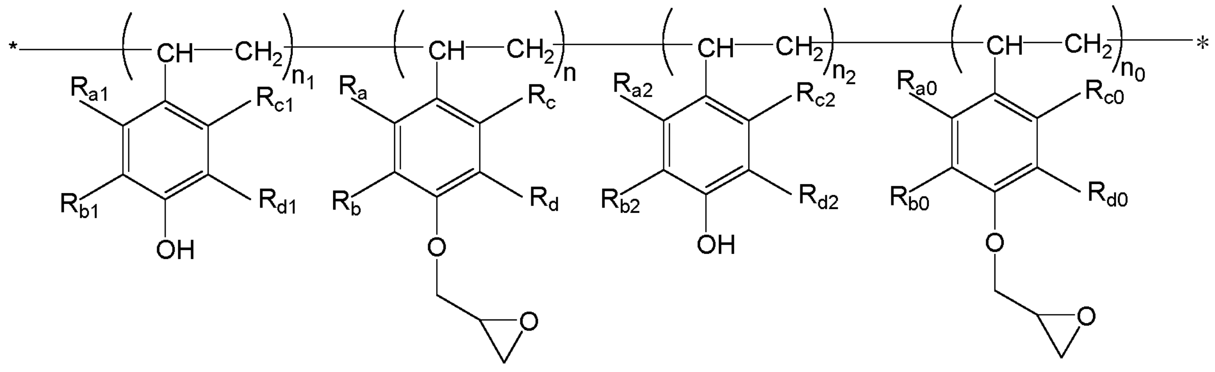

(I)

worin :

jedes $R_a$-$R_d$, jedes $R_{a0}$-$R_{d0}$, jedes $R_{a1}$-$R_{d1}$, und jedes $R_{a2}$-$R_{d2}$ jeweils unabhängig voneinander ausgewählt ist aus der Gruppe bestehend aus H, Halogen, $C_1$-$C_6$-Alkyl, Halogen-$C_1$-$C_6$-Alkyl, $C_1$-$C_6$-Alkoxy, Halogen-$C_1$-$C_6$-Alkoxy, $C_3$-$C_{12}$-Cycloalkyl und Halogen-$C_3$-$C_{12}$-Cycloalkyl;
n und no jeweils unabhängig voneinander eine Zahl von 0 bis 40 sind, und $n+n_0$ eine Zahl von 20 bis 40 ist; und $n_1$ und $n_2$ jeweils unabhängig voneinander eine Zahl von 0 bis 2 sind, und/oder $n_1+n_2$ eine Zahl von 0 bis 3 ist;
erhältlich durch ein Verfahren, das die Umsetzung eines Polymers der Formel (II) mit einer Verbindung der Formel (III) umfasst,

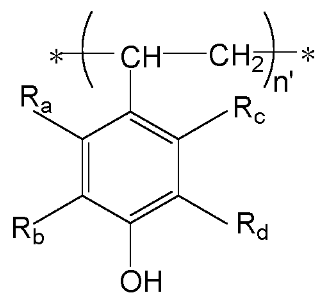

(II)

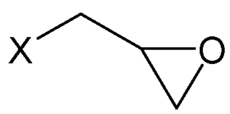

(III)

worin $n'=n+n_0+n_1+n_2$, $R_a$-$R_d$, n, $n_0$, $n_1$ und $n_2$ jeweils wie oben definiert sind, und X ein Halogen, vorzugsweise Chlor oder Brom ist,
wobei die Umsetzung des Polymers der Formel (II) mit der Verbindung der Formel (III) in Gegenwart eines alkalischen Katalysators durchgeführt wird, der vorzugsweise einer oder mehrere ausgewählt aus der Gruppe bestehend aus NaOH, KOH, $Na_2CO_3$, $K_2CO_3$, besonders bevorzugt $K_2CO_3$, ist;
wobei das Polymer der Formel (II) und die Verbindung der Formel (III) in einer solchen Menge verwendet werden, dass das Molverhältnis der in dem Polymer der Formel (II) enthaltenen Monomereinheit zu der Verbindung der Formel (III) von 1:1 bis 1:3, vorzugsweise von 1:1,8 bis 1:2,0 beträgt; und
wobei die Umsetzung des Polymers der Formel (II) mit der Verbindung der Formel (III) bei 0-30°C, vorzugsweise 25-30°C, durchgeführt wird.

2. Polymer gemäß Anspruch 1, wobei jedes $R_a$-$R_d$, jedes $R_{a0}$-$R_{d0}$, jedes $R_{a1}$-$R_{d1}$, und jedes $R_{a2}$-$R_{d2}$ jeweils unabhängig voneinander ausgewählt ist aus H, Chlor, Brom, $C_1$-$C_4$-Alkyl, Chlor-$C_1$-$C_4$-Alkyl, Brom-$C_1$-$C_4$-Alkyl, $C_1$-$C_4$-Alkoxy, Chlor-$C_1$-$C_4$-Alkoxy und Brom-$C_1$-$C_4$-Alkoxy, bevorzugt sind $R_a$-$R_d$, $R_{a0}$-$R_{d0}$, $R_{a1}$-$R_{d1}$, und $R_{a2}$-$R_{d2}$ alle H.

3. Verbindung gemäß Anspruch 1 oder 2, wobei n und $n_0$ jeweils unabhängig voneinander eine Zahl von 0 bis 20, vorzugsweise eine Zahl von 12 bis 18 sind, und $n+n_0$ eine Zahl von 24 bis 36, vorzugsweise eine Zahl von 25 bis 30 ist.

4. Polymer gemäß irgendeinem der Ansprüche 1 bis 3, wobei $n_1$ und $n_2$ jeweils unabhängig voneinander 0 sind; und/oder $n_1+n_2$ 0 ist.

5. Verfahren zur Herstellung eines Polymers der Formel (I) gemäß irgendeinem der Ansprüche 1 bis 4, **dadurch gekennzeichnet, dass** ein Polymer der Formel (II) mit einer Verbindung der Formel (III) umgesetzt wird,

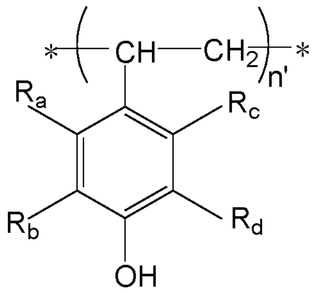

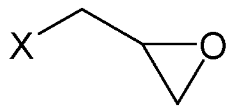

(II) (III)

worin $n'=n+n_0+n_1+n_2$, $R_a$-$R_d$, n, $n_0$, $n_1$ und $n_2$ jeweils wie in einem der Ansprüche 1 bis 4 definiert sind, und X ein Halogen, vorzugsweise Chlor oder Brom, ist;
wobei die Umsetzung des Polymers der Formel (II) mit der Verbindung der Formel (III) in Gegenwart eines alkalischen Katalysators durchgeführt wird, der vorzugsweise einer oder mehrere ausgewählt aus der Gruppe bestehend aus NaOH, KOH, $Na_2CO_3$, $K_2CO_3$, besonders bevorzugt $K_2CO_3$, ist;
wobei das Polymer der Formel (II) und die Verbindung der Formel (III) in einer solchen Menge verwendet werden, dass das Molverhältnis der in dem Polymer der Formel (II) enthaltenen Monomereinheit zu der Verbindung der Formel (III) von 1:1 bis 1:3, vorzugsweise von 1:1,8 bis 1:2,0, beträgt; und wobei die Umsetzung des Polymers der Formel (II) mit der Verbindung der Formel (III) bei 0-30°C, vorzugsweise bei 25-30°C, durchgeführt wird.

6. Verfahren gemäß Anspruch 5, **dadurch gekennzeichnet, dass** das Polymer der Formel (II) und der alkalische Katalysator in einer solchen Menge eingesetzt werden, dass das molare Verhältnis der im Polymer der Formel (II) enthaltenen Monomereinheit zum alkalischen Katalysator 1:0,1 bis 1:1, vorzugsweise 1:0,6 bis 1:1 beträgt.

7. Verwendung eines Polymers der Formel (I) gemäß irgendeinem der Ansprüche 1 bis 4 als filmbildendes Harz in einem Photoresist.

8. Photoresist, umfassend ein Polymer der Formel (I)

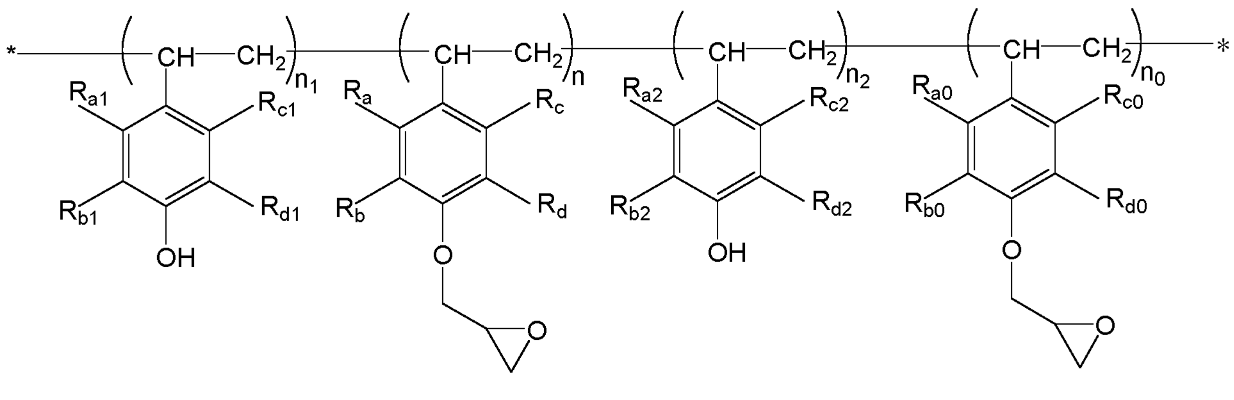

(I)

worin:

jedes $R_a$-$R_d$, jedes $R_{a0}$-$R_{d0}$, jedes $R_{a1}$-$R_{d1}$, und jedes $R_{a2}$-$R_{d2}$ jeweils unabhängig voneinander ausgewählt sind aus der Gruppe bestehend aus H, Halogen, $C_1$-$C_6$-Alkyl, Halogen-$C_1$-$C_6$-Alkyl, $C_1$-$C_6$-Alkoxy, Halogen-$C_1$-$C_6$-Alkoxy, $C_3$-$C_{12}$-Cycloalkyl und Halogen-$C_3$-$C_{12}$-Cycloalkyl;
n und no jeweils unabhängig voneinander eine Zahl von 0 bis 40 sind, und $n+n_0$ eine Zahl von 20 bis 40 ist; und

$n_1$ und $n_2$ jeweils unabhängig voneinander eine Zahl von 0 bis 2, vorzugsweise 0, sind; und/oder $n_1+n_2$ eine Zahl von 0 bis 3, vorzugsweise 0, ist,
als ein filmbildendes Harz.

**9.** Photoresist gemäß Anspruch 8, wobei jedes $R_a$-$R_d$, jedes $R_{a0}$-$R_{d0}$, jedes $R_{a1}$-$R_{d1}$, und jedes $R_{a2}$-$R_{d2}$ jeweils unabhängig voneinander ausgewählt ist aus H, Chlor, Brom, $C_1$-$C_4$-Alkyl, Chlor-$C_1$-$C_4$-Alkyl, Brom-$C_1$-$C_4$-Alkyl, $C_1$-$C_4$-Alkoxy, Chlor-$C_1$-$C_4$-Alkoxy und Brom-$C_1$-$C_4$-Alkoxy; bevorzugt sind $R_a$-$R_d$, $R_{a0}$-$R_{d0}$, $R_{a1}$-$R_{d1}$, und $R_{a2}$-$R_{d2}$ alle H.

**10.** Photoresist gemäß Anspruch 8 oder 9, wobei n und $n_0$ jeweils unabhängig voneinander üblicherweise eine Zahl von 0 bis 20, vorzugsweise eine Zahl von 12 bis 18 sind, und $n+n_0$ eine Zahl von 24 bis 36, vorzugsweise eine Zahl von 25 bis 30 ist.

**11.** Photoresist gemäß irgendeinem der Ansprüche 8 bis 10, umfassend das Polymer der Formel (I) gemäß irgendeinem der Ansprüche 8 bis 10 als filmbildendes Harz, einen Photosäuregenerator, ein photopolymerisierbares Monomer, ein alkalisches Additiv, einen Sensibilisator und ein Photoresistlösungsmittel; vorzugsweise ist das Massenverhältnis von filmbildendem Harz, Photosäuregenerator, photopolymerisierbarem Monomer, alkalischem Additiv, Sensibilisator und Photoresistlösungsmittel (30-40): (1-4): (20-25): (1-2): (0-2): (40-50); besonders bevorzugt ist das Massenverhältnis des filmbildenden Harzes, des Photosäuregenerators, des photopolymerisierbaren Monomers, des alkalischen Additivs, des Sensibilisators und des Photoresistlösungsmittels 35 : 3,0 : 25 : 1,5 : 1,5 : 50.

**12.** Photoresist gemäß Anspruch 11, wobei der Photosäuregenerator eines oder mehrere von einem Iodoniumsalz, einem Sulfoniumsalz und einem heterocyclischen Säuregenerator ist; bevorzugt ist das Iodoniumsalz, das Sulfoniumsalz und der heterocyclische Säuregenerator eines der Formeln (IV), (V) bzw. (VI):

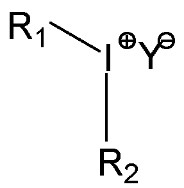
(IV)

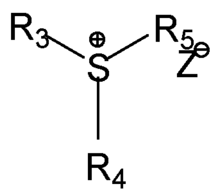
(V)

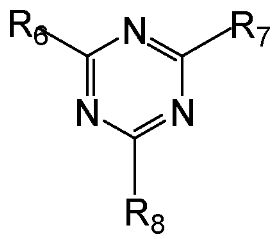
(VI)

worin $R_1$, $R_2$, $R_3$, $R_4$, $R_5$, $R_6$, $R_7$ and $R_8$ jeweils unabhängig voneinander Phenyl, Halogenphenyl, Nitrophenyl, $C_6$-$C_{10}$-Aryl oder C1-$C_{10}$-alkylsubstituiertes Benzoyl sind; und
Y, Z nicht-nukleophile Anionen wie Triflat, $BF_4^-$, $ClO_4^-$, $PF_6^-$, $AsF_6^-$ oder $SbF_6^-$ sind.

**13.** Photoresist gemäß Anspruch 11 oder 12, wobei

das photopolymerisierbare Monomer N-Vinylpyrrolidon, Hydroxyethylmethacrylat oder eine Mischung davon ist; und/oder
das alkalische Additiv ein tertiäres Amin und/oder ein quaternäres Amin ist, vorzugsweise eines oder mehrere von Triethanolamin, Trioctylamin und Tributylamin; und/oder
der Sensibilisator eines oder mehrere von 2,4-Diethylthioxanthon, 9-Anthracenmethanol und 1-[(2,4-Dimethylphenyl)azo]-2-naphthol ist; und/oder
das Photoresistlösungsmittel eines oder mehrere von Cyclopentanon, γ-Butyrolacton und Ethylacetat ist.

## Revendications

**1.** Polymère de formule (I)

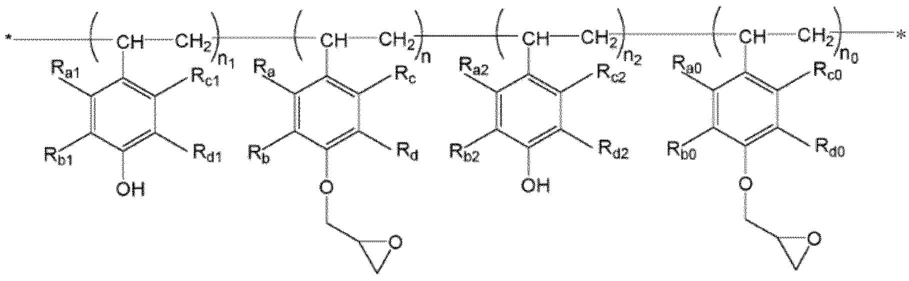

(I)

chacun parmi $R_a$-$R_d$, chacun parmi $R_{a0}$-$R_{d0}$, chacun parmi $R_{a1}$-$R_{d1}$, et chacun parmi $R_{a2}$-$R_{d2}$ étant respectivement indépendamment choisis dans le groupe constitué par H, halogène, $C_1$-$C_6$ alkyle, halogéno $C_1$-$C_6$ alkyle, $C_1$-$C_6$ alcoxy, halogéno $C_1$-$C_6$ alcoxy, $C_3$-$C_{12}$ cycloalkyle et halogéno $C_3$-$C_{12}$ cycloalkyle ;
n et $n_0$ étant chacun indépendamment un nombre de 0 à 40, et n + $n_0$ étant un nombre de 20 à 40 ; et
$n_1$ et $n_2$ étant chacun indépendamment un nombre de 0 à 2, et/ou $n_1$ + $n_2$ étant un nombre de 0 à 3 ;
pouvant être obtenu par un procédé qui comprend la mise en réaction d'un polymère de formule (II) avec un composé de formule (III),

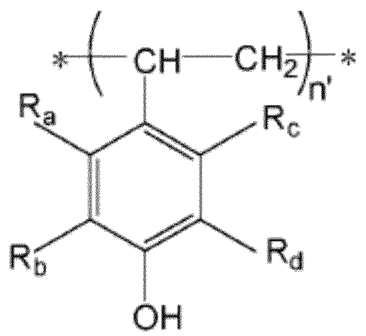

(II)

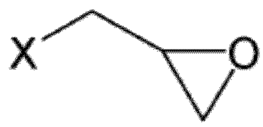

(III)

n' = n + $n_0$ + $n_1$ + $n_2$, $R_a$-$R_d$, n, $n_0$, $n_1$ et $n_2$ étant chacun tels que définis ci-dessus, et X étant un halogène, préférablement chlore ou brome,
la réaction du polymère de formule (II) avec le composé de formule (III) étant réalisée en la présence d'un catalyseur alcalin, qui est préférablement l'un ou plusieurs choisis dans le groupe constitué par NaOH, KOH, $Na_2CO_3$, $K_2CO_3$, plus préférablement $K_2CO_3$,
le polymère de formule (II) et le composé de formule (III) étant utilisés en une quantité telle que le rapport molaire du motif monomérique contenu dans le polymère de formule (II) sur le composé de formule (III) soit de 1 : 1 à 1 : 3, préférablement de 1 : 1,8 à 1 : 2,0 ; et
la réaction du polymère de formule (II) avec le composé de formule (III) étant réalisée à une température de 0 à 30 °C, préférablement à une température de 25 à 30°C.

2. Polymère selon la revendication 1, chacun parmi $R_a$-$R_d$, chacun parmi $R_{a0}$-$R_{d0}$, chacun parmi $R_{a1}$-$R_{d1}$, et chacun parmi $R_{a2}$-$R_{d2}$ étant respectivement indépendamment choisis parmi H, chloro, bromo, $C_1$-$C_4$ alkyle, chloro $C_1$-$C_4$ alkyle, bromo $C_1$-$C_4$ alkyle, $C_1$-$C_4$ alcoxy, chloro $C_1$-$C_4$ alcoxy et bromo $C_1$-$C_4$ alcoxy ; préférablement, $R_a$-$R_d$, $R_{a0}$-$R_{d0}$, $R_{a1}$-$R_{d1}$, et $R_{a2}$-$R_{d2}$ étant tous H.

3. Composé selon la revendication 1 ou 2, n et $n_0$ étant chacun indépendamment un nombre de 0 à 20, préférablement un nombre de 12 à 18, et n + $n_0$ étant un nombre de 24 à 36, préférablement un nombre de 25 à 30.

4. Polymère selon l'une quelconque des revendications 1 à 3, $n_1$ et $n_2$ étant chacun indépendamment 0 ; et/ou $n_1$ + $n_2$ étant 0.

5. Procédé pour la préparation d'un polymère de formule (I) selon l'une quelconque des revendications 1 à 4, qui comprend la mise en réaction d'un polymère de formule (II) avec un composé de formule (III),

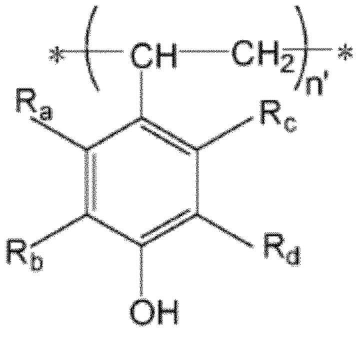

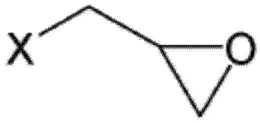

(II) (III)

$n' = n + n_0 + n_2 + n_2$, $R_a$-$R_d$, n, $n_0$, $n_2$ et $n_2$ étant chacun tels que définis dans l'une quelconque des revendications 1 à 4, et X étant un halogène, préférablement chlore ou brome,
la réaction du polymère de formule (II) avec le composé de formule (III) étant réalisée en la présence d'un catalyseur alcalin, qui est préférablement l'un ou plusieurs choisis dans le groupe constitué par NaOH, KOH, $Na_2CO_3$, $K_2CO_3$, plus préférablement $K_2CO_3$ ;
le polymère de formule (II) et le composé de formule (III) étant utilisés en une quantité telle que le rapport molaire du motif monomérique contenu dans le polymère de formule (II) sur le composé de formule (III) est de 1 : 1 à 1 : 3, préférablement de 1 : 1,8 à 1 : 2,0 ; et
la réaction du polymère de formule (II) avec le composé de formule (III) étant réalisée à une température de 0 à 30 °C, préférablement à une température de 25 à 30°C.

**6.** Procédé selon la revendication 5, le polymère de formule (II) et le catalyseur alcalin étant utilisés en une quantité telle que le rapport molaire du motif monomérique contenu dans le polymère de formule (II) sur le catalyseur alcalin est de 1 : 0,1 à 1 : 1, préférablement de 1 : 0,6 à 1 : 1.

**7.** Utilisation d'un polymère de formule (I) selon l'une quelconque des revendications 1 à 4 en tant que résine filmogène dans une photorésine.

**8.** Photorésine comprenant un polymère de formule (I)

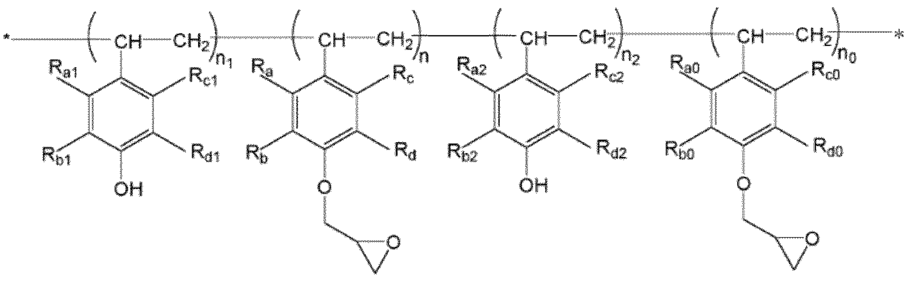

(I)

chacun parmi $R_a$-$R_d$, chacun parmi $R_{a0}$-$R_{d0}$, chacun parmi $R_{a1}$-$R_{d1}$, et chacun parmi $R_{a2}$-$R_{d2}$ étant respectivement indépendamment choisis dans le groupe constitué par H, halogène, $C_1$-$C_6$ alkyle, halogène $C_1$-$C_6$ alkyle, $C_1$-$C_6$ alcoxy, halogène $C_1$-$C_6$ alcoxy, $C_3$-$C_{12}$ cycloalkyle et halogène $C_3$-$C_{12}$ cycloalkyle ;
n et $n_0$ étant chacun indépendamment un nombre de 0 à 40, et $n + n_0$ étant un nombre de 20 à 40 ; et
$n_1$ et $n_2$ étant chacun indépendamment un nombre de 0 à 2, préférablement 0 ; et/ou $n_1 + n_2$ étant un nombre de 0 à 3, et préférablement 0,
en tant que résine filmogène.

**9.** Photorésine selon la revendication 8, chacun parmi $R_a$-$R_d$, chacun parmi $R_{a0}$-$R_{d0}$, chacun parmi $R_{a1}$-$R_{d1}$, et chacun parmi $R_{a2}$-$R_{d2}$ étant respectivement indépendamment choisis parmi H, chloro, bromo, $C_1$-$C_4$ alkyle, chloro $C_1$-$C_4$ alkyle, bromo $C_1$-$C_4$ alkyle, $C_1$-$C_4$ alcoxy, chloro $C_1$-$C_4$ alcoxy et bromo $C_1$-$C_4$ alcoxy ; préférablement, $R_a$-$R_d$, $R_{a0}$-$R_{d0}$, $R_{a1}$-$R_{d1}$, et $R_{a2}$-$R_{d2}$ étant tous H.

**10.** Photorésine selon la revendication 8 ou 9, n et $n_0$ étant chacun indépendamment habituellement un nombre de 0 à 20, préférablement un nombre de 12 à 18, et n + $n_0$ étant un nombre de 24 à 36, préférablement un nombre de 25 à 30.

**11.** Photorésine selon l'une quelconque revendication 8 à 10, qui comprend le polymère de formule (I) selon l'une quelconque des revendications 8 à 10 en tant qu'une résine filmogène, un générateur de photoacide, un monomère photopolymérisable, un additif alcalin, un agent sensibilisant et un solvant de photorésine ; préférablement, le rapport en masse de la résine filmogène, du générateur de photoacide, du monomère photopolymérisable, de l'additif alcalin, de l'agent sensibilisant, et du solvant de photorésine étant de (30-40) : (1-4) : (20-25) : (1-2) : (0-2) : (40-50) ; plus préférablement, le rapport en masse de la résine filmogène, du générateur de photoacide, du monomère photopolymérisable, de l'additif alcalin, de l'agent sensibilisant, et du solvant de photorésine étant de 35 : 3,0 : 25 : 1,5 : 1,5 : 50.

**12.** Photorésine selon la revendication 11, le générateur de photoacide étant l'un quelconque ou plusieurs parmi un sel d'iodonium, un sel de sulfonium, et un générateur d'acide hétérocyclique ; préférablement, les générateurs d'acide de type sel d'iodonium, sel de sulfonium et hétérocycliques étant respectivement des formules (IV), (V) et (VI) :

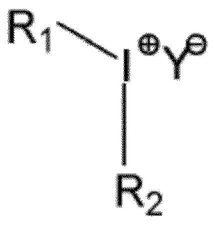
(IV)

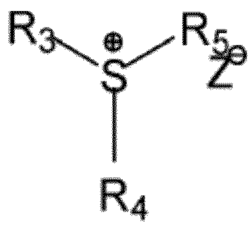
(V)

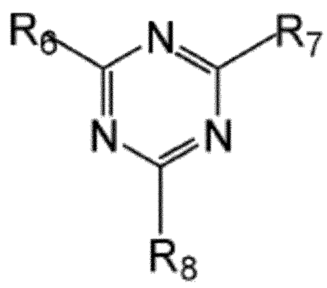
(VI)

$R_1$, $R_2$, $R_3$, $R_4$, $R_5$, $R_6$, $R_7$ et $R_8$ étant chacun indépendamment phényle, halogénophényle, nitrophényle, $C_6$-$C_{10}$ aryle ou benzoyle substitué par $C_1$-$C_{10}$ alkyle ; et
Y, Z étant des anions non nucléophiles tels que triflate, $BF_4^-$, $ClO_4^-$, $PF_6^-$, $AsF_6^-$ ou $SbF_6^-$.

**13.** Photorésine selon la revendication 11 ou 12,

le monomère photopolymérisable étant la N-vinylpyrrolidone, le méthacrylate d'hydroxyéthyle ou un mélange correspondant ; et/ou
l'additif alcalin étant une amine tertiaire et/ou une amine quaternaire, plus préférablement l'une quelconque ou plusieurs parmi la triéthanolamine, la trioctylamine et la tributylamine ; et/ou
l'agent sensibilisant étant l'un quelconque ou plusieurs parmi la 2,4-diéthylthioxanthone, le 9-anthracèneméthanol et le 1-[(2,4-diméthylphényl)azo]-2-naphtol ; et/ou
le solvant de photorésine étant l'un quelconque ou plusieurs parmi la cyclopentanone, la γ-butyrolactone, et l'acétate d'éthyle.

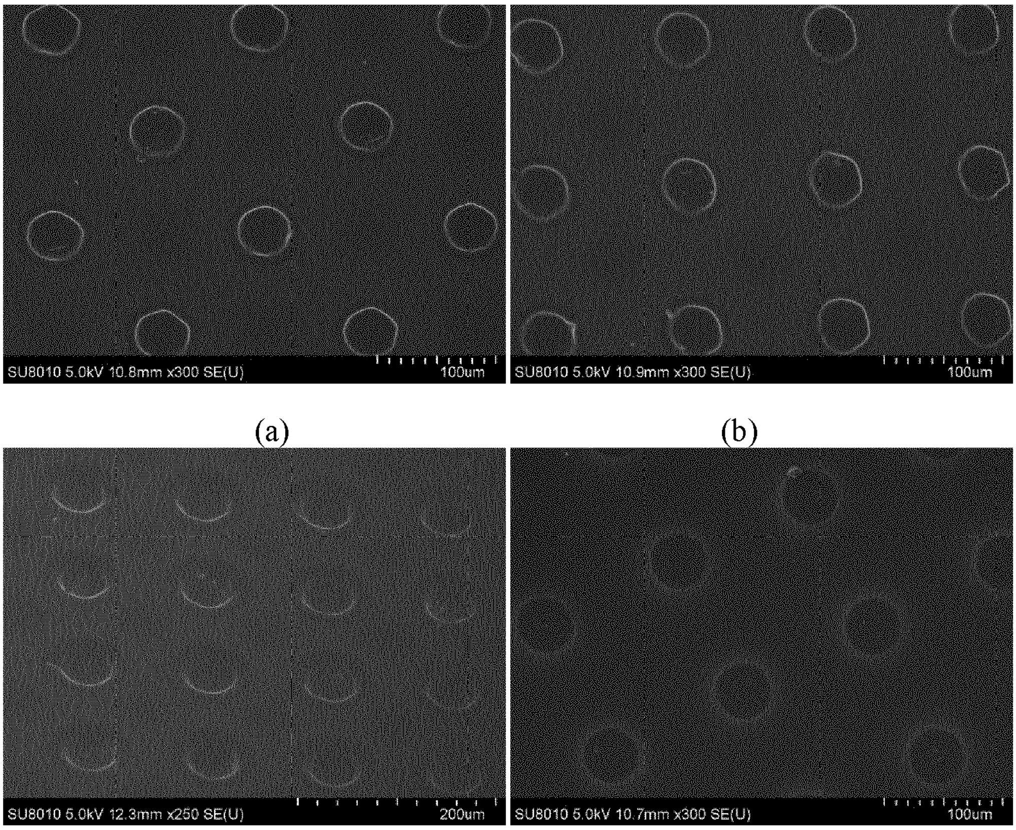


(a) (b)

(c) (d)

Figure 1

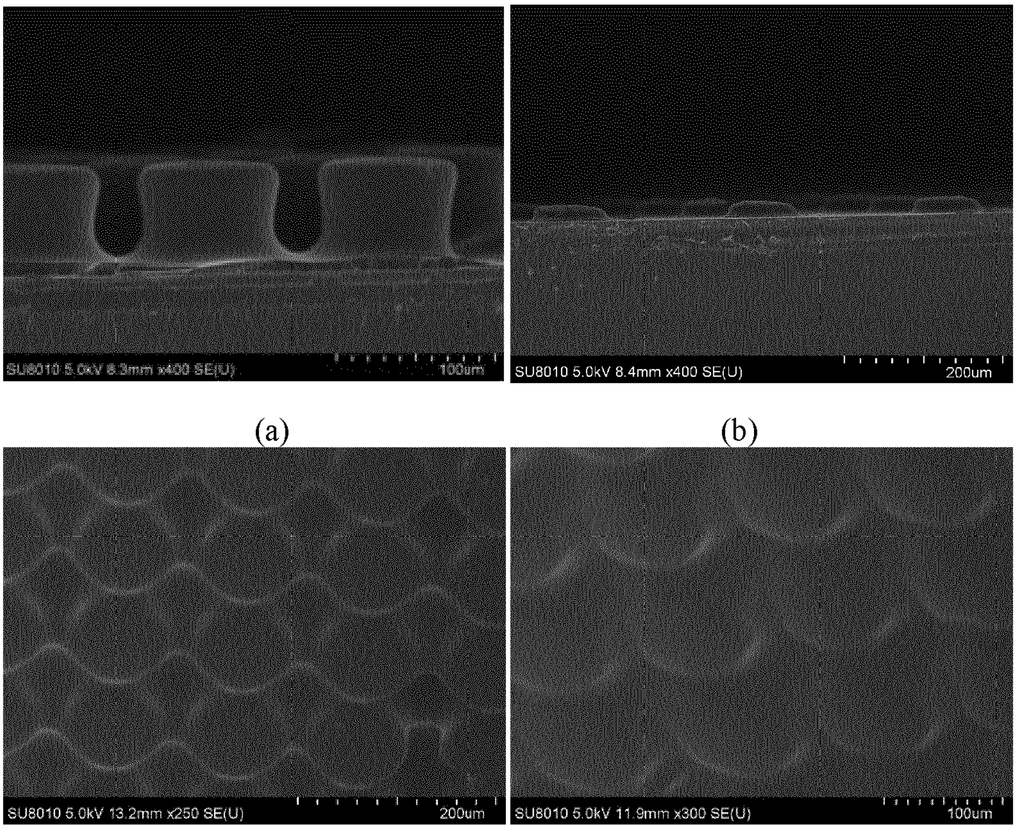


(a) (b)

(c) (d)

Figure 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002229204 A